# EUROPEAN PATENT SPECIFICATION

(11) **EP 4 528 795 B1**
(45) Date of publication and mention of the grant of the patent: **29.04.2026**
(21) Application number: 24200234.3
(22) Date of filing: 13.09.2024
(51) Int. Cl.: H10P 72/00

(54) **SUBSTRATE TREATMENT METHOD AND SUBSTRATE TREATMENT APPARATUS**
VERFAHREN UND VORRICHTUNG ZUR BEHANDLUNG VON SUBSTRATEN
MÉTHODE DE TRAITEMENT DES SUBSTRATS ET APPAREIL DE TRAITEMENT DES SUBSTRATS

(30) Priority: 22.09.2023 JP 2023156697
(43) Date of publication of application: 26.03.2025
(73) Proprietor: SCREEN Holdings Co., Ltd., Kyoto-shi, Kyoto 602-8585 (JP)
(72) Inventor: Tanaka, Yuji, Kyoto, 602-8585 (JP); Harumoto, Masahiko, Kyoto, 602-8585 (JP)
(74) Representative: Kilian Kilian & Partner mbB

(56) References cited:
- US-A1- 2003 053 039
- US-A1- 2011 155 327
- US-A1- 2019 378 739

## Description

### BACKGROUND OF THE INVENTION

### Field of the Invention

The present invention relates to a substrate treatment method of forming a coating film on a peripheral edge part of a disk-shaped substrate having a notched part such as a notch and a substrate treatment apparatus. Examples of a substrate to be treated include a semiconductor wafer, a substrate for a liquid crystal display device, a substrate for a flat panel display (FPD), a substrate for an optical disk, a substrate for a magnetic disk, or a substrate for a solar cell.

### Description of the Background Art

In photolithography as an important technique for forming a pattern in a process of manufacturing a semiconductor device, a development treatment is performed after a resist film is formed on a substrate of a semiconductor wafer, for example, and a pattern exposure is performed on the resist film. When a transfer arm or a positioning part, for example, has contact with an end edge part of a substrate with a resist film on a whole surface thereof, a defect occurs in the resist film to cause dust, and there is a possibility that the transfer arm, for example, is contaminated by the dust. Thus, a solvent is supplied to a peripheral edge part of the substrate to remove the resist film on the peripheral edge part. Accordingly, a silicon base material is exposed in the peripheral edge part of the substrate.

For example, when a deep reactive ion etching (DRIE) process is executed using a resist film on which a pattern is formed as a mask, a damage occurs in the peripheral edge part of the substrate where the base material is exposed. Then, strength of the peripheral edge part of the substrate decreases, and particles may occur. Thus, Japanese Patent Application Laid-Open Nos. 7-130703 and 2002-334879 disclose a technique of forming a protection film for preventing etching on a peripheral edge part of the substrate.

US 2019/378739 discloses a substrate treating method of forming a coating film on a peripheral edge part of a disk-shaped substrate and a corresponding apparatus according to the prior art.

In order to form the protection film on the peripheral edge part of the substrate, a coating solution is typically supplied to an upper surface of the peripheral edge part of the rotated substrate from a nozzle, and is then dried to form the coating film. A width of the coating film is preferably as uniform and narrow as possible over a whole peripheral edge part of the substrate.

However, when the nozzle discharging the coating solution is moved to a predetermined position on an upper side of the peripheral edge part of the rotated substrate and the substrate is rotated once, the width of the coating film gradually gets larger from start of the coating, and a uniform width is hardly achieved. Thus, the width of the coating film needs to be adjusted to be uniform by rotating the substrate several times while the nozzle is held at a predetermined position. However, according to such a process, the coating solution is applied again over plural turns to the peripheral edge part of the substrate, thus a supply amount of the coating solution to the substrate increases, and the width of the coating film resultingly and correspondingly gets also large. When the holding position of the nozzle is located to an end edge part side of the substrate as close as possible, the width of the coating film can be reduced at least, however, the coating solution tends to significantly extend to a center side of the substrate by surface tension, thus it is difficult to make the width of the coating film narrower than a certain value.

### SUMMARY

The present invention is directed to a substrate treatment method of forming a coating film on a peripheral edge part of a disk-shaped substrate having a notched part.

According to one aspect of the present invention, a substrate treatment method includes: (a) moving a nozzle discharging a coating solution for forming the coating film to a discharge position where a flow of the coating solution discharged from the nozzle passes through the notched part of the substrate held in a horizontal posture; and (b) rotating the substrate once in a horizontal plane around a central axis of the substrate while discharging the coating solution from the nozzle in the discharge position, starting application of the coating solution from the notched part, and finishing application of the coating solution at the notched part.

The coating solution is applied only once without overlapping, thus a coating film having a uniform and narrow width can be formed.

Discharge of the coating solution from the nozzle is preferably started before the nozzle reaches the discharge position.

The application can be started while the coating solution is stably discharged, thus the coating film can be formed more uniformly.

The present invention is also directed to a substrate treatment apparatus forming a coating film on a peripheral edge part of a disk-shaped substrate having a notched part.

According to one aspect of the present invention, a substrate treatment apparatus includes: a rotation holding part rotating the substrate around a central axis of the substrate while holding the substrate in a horizontal posture; a nozzle discharging a coating solution for forming the coating film; a nozzle drive part moving the nozzle between an upper side and an outer side of the substrate; and a controller controlling the rotation holding part and the nozzle drive part, wherein the controller controls the nozzle drive part so that the nozzle is moved to a discharge position where a flow of the coating solution discharged from the nozzle passes through the notched part of the substrate held by the rotation holding part, and the controller controls the rotation holding part so that the rotation holding part rotates the substrate once in a horizontal plane around a central axis of the substrate while discharging the coating solution from the nozzle in the discharge position, application of the coating solution is started from the notched part, and application of the coating solution is finished at the notched part.

The coating solution is applied only once without overlapping, thus a coating film having a narrow width can be uniformly formed.

Discharge of the coating solution is preferably started before the nozzle reaches the discharge position.

The application can be started while the coating solution is stably discharged, thus the coating film can be formed more uniformly.

Accordingly, an object of the present invention is to form a coating film with a uniform and narrow width.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram illustrating a schematic configuration of a substrate treatment apparatus according to the present invention.
Fig. 2 is a flow chart illustrating a procedure of a treatment operation in the substrate treatment apparatus.
Fig. 3 is a plan view of a substrate to be treated in the substrate treatment apparatus.
Fig. 4 is a plan view illustrating a coating nozzle moving to an upper side of a notch of the substrate.
Fig. 5 is a plan view illustrating formation of a coating film on the substrate.
Fig. 6 is a side view schematically illustrating formation of the coating film.
Fig. 7 is a plan view illustrating the coating nozzle retracting from the upper side of the notch of the substrate.
Fig. 8 is a diagram schematically illustrating drying of the coating film.
Fig. 9 is a diagram schematically illustrating cleaning of a back surface of the substrate.
Fig. 10 is a diagram illustrating a trajectory of a relative movement of the coating nozzle on the substrate according to a second embodiment.

### DESCRIPTION OF THE PREFERRED EMBODIMENTS

Embodiments according to the present invention will now be described in detail with reference to the drawings. In the description hereinafter, unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", and "uniform") include those indicating quantitatively exact equality and those in the presence of a difference within tolerance or to the extent that similar functions can be obtained. Unless otherwise noted, the expressions indicating shapes (e.g., "circular", "rectangular", and "cylindrical") include those indicating geometrically exact shapes and those indicating, for example, roughness or a chamfer to the extent that similar effect can be obtained. An expression "comprising", "including", or "having" a certain constituent element is not an exclusive expression for excluding the presence of the other constituent elements. An expression "at least one of A, B, and C" involves "only A", "only B", "only C", "arbitrary two of A, B, and C", and "all of A, B, and C".

### <First embodiment>

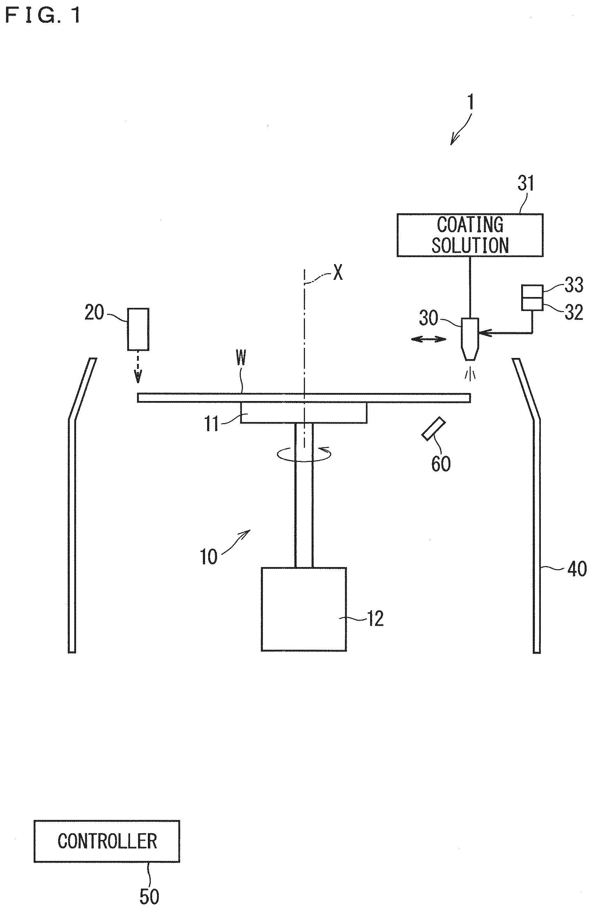

Fig. 1 is a diagram illustrating a schematic configuration of a substrate treatment apparatus 1 according to the present invention. The substrate treatment apparatus 1 in Fig. 1 is a coating apparatus (spin coater) supplying a predetermined coating solution to a peripheral edge part of a disk-shaped substrate W while rotating the substrate W and forming a coating film. The substrate W to be treated is a silicon semiconductor wafer, for example. A size of the semiconductor wafer is not particularly limited, but has a diameter of 300 mm or 450 mm, for example (300 mm in the present embodiment).

The substrate treatment apparatus 1 includes a rotation holding part 10 and a coating nozzle 30 as main elements. The substrate treatment apparatus 1 includes a controller 50 controlling various operating mechanisms provided inside the substrate treatment apparatus 1 and proceeding with a treatment on the substrate W.

The rotation holding part 10 includes a spin chuck 11 and a spin motor 12. The spin chuck 11 is a substrate holding part holding the substrate W in a horizontal posture (posture in which a normal line of a main surface of the substrate W follows a vertical direction). The spin chuck 11 is a vacuum suction chuck, for example. The spin chuck 11 has a disk-like shape with a diameter smaller than the substrate W. The spin chuck 11 sucks and holds a center part of a lower surface of the substrate W. In a state where the lower surface of the substrate W is sucked and held by the spin chuck 11, the peripheral edge part of the substrate W protrudes to an outer side of an outer surrounding end of the spin chuck 11. The spin chuck 11 may be a chuck in the other form such as a sandwiching-type mechanical chuck.

The spin chuck 11 is connected to the spin motor 12 via a motor shaft. That is to say, an upper end of the motor shaft of the spin motor 12 is connected to a center part of the lower surface of the spin chuck 11. When the spin motor 12 rotates the motor shaft while the substrate W is sucked and held by the spin chuck 11, the substrate W and the spin chuck 11 are rotated in a horizontal plane around a central axis X of the substrate W along a vertical direction.

A cup 40 is provided to surround the spin chuck 11. The cup 40 can go up and down by an elevating mechanism not illustrated in the diagrams. The cup 40 has a cylindrical shape, and an upper part of the cup 40 is inclined to get closer to the spin chuck 11 toward an upper side. However, an inner diameter of an upper end part of the cup 40 is larger than the diameter of the substrate W. In treatment of the substrate W, the upper end of the cup 40 is located in a higher position than a height position of the substrate W held by the spin chuck 11. Accordingly, a liquid flying in all directions from the substrate W rotated by the spin motor 12 by centrifugal force is received by the cup 40 and collected. The liquid collected by the cup 40 is discharged from a discharge solution pipe provided to a bottom part of the cup 40. The cup 40 may have a multi-stage structure that a plurality of collection ports are provided for various purposes.

The coating nozzle 30 discharges a coating solution to the substrate W held by the spin chuck 11. In the present embodiment, the coating nozzle 30 discharges the coating solution toward a lower side in a vertical direction. The coating nozzle 30 is connected to a coating solution supply part 31 via a pipe. The coating solution supply part 31 feeds the coating solution to the coating nozzle 30. The coating solution of the present embodiment is a treatment solution forming a coating film functioning as a protection film having resistance to an etching treatment such as DRIE when being dried, and a solution for forming the photoresist or a bottom layer film, for example, is used. Exemplified as a solution for forming the bottom layer film is a spin-on-glass (SOG) solution including a silicon-containing polymer or a spin-on-carbon (SOC) solution including a carbon-containing polymer, for example.

The coating nozzle 30 can be moved by a nozzle drive mechanism 32 conceptually illustrated in Fig. 1 between an upper side and an outer side (inner side of the cup 40) of the substrate W held by the spin chuck 11. The nozzle drive mechanism 32 can also move the coating nozzle 30 to a waiting position on an outer side of the cup 40. Furthermore, the nozzle drive mechanism 32 can reciprocate the coating nozzle 30 between an upper side of a center part of the substrate W held by the spin chuck 11 and an upper side of the peripheral edge part thereof. The nozzle drive mechanism 32 may be a mechanism moving the coating nozzle 30 along an arc-shaped trajectory (mechanism pivoting a nozzle arm) or a mechanism linearly moving the coating nozzle 30 along a radial direction of the substrate W (linear drive mechanism).

The nozzle drive mechanism 32 is provided with an encoder 33. The encoder 33 detects a position of the coating nozzle 30 moved by the nozzle drive mechanism 32. Adopted as the encoder 33 are a rotary encoder when the nozzle drive mechanism 32 is a mechanism pivoting the coating nozzle 30 and a linear encoder when the nozzle drive mechanism 32 is a linear drive mechanism.

The substrate treatment apparatus 1 includes a notch detection mechanism 20. The notch detection mechanism 20 is provided to an upper side or a lower side of the peripheral edge part of the substrate W held by the spin chuck 11. The notch detection mechanism 20 emits laser light, for example, and detects reflection light thereof to detect a notch formed in the substrate W.

Furthermore, the substrate treatment apparatus 1 includes a back rinse nozzle 60. The back rinse nozzle 60 is disposed and fixed to a lower side of the substrate W held by the spin chuck 11. The back rinse nozzle 60 is provided to be inclined so that a discharge direction is directed to obliquely upper side from a center side of the substrate W toward an end edge part side thereof. The back rinse nozzle 60 discharges a liquid including propylene glycol monomethyl ether acetate (PGMEA) or propylene glycol monomethyl ether (PGME), or cyclohexane, for example, as a rinse solution.

The controller 50 controls various operating mechanisms provided to the substrate treatment apparatus 1. The controller 50 is similar in hardware configuration to a typical computer. Specifically, the controller 50 includes a CPU that is a circuit for performing various computation processes, a ROM or read-only memory for storing a basic program therein, a RAM or readable/writable memory for storing various pieces of information therein, and a storage part (magnetic disk or SSD) for storing control software, data and the like therein. When a CPU of the controller 50 executes a predetermined treatment program to control operations of the rotation holding part 10 and the coating nozzle 30, the treatment of the substrate W in the substrate treatment apparatus 1 proceeds.

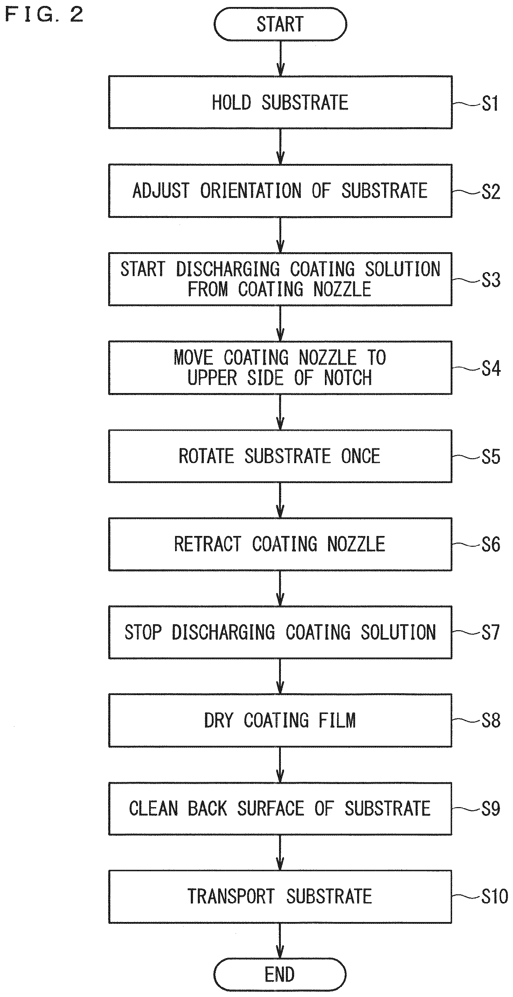

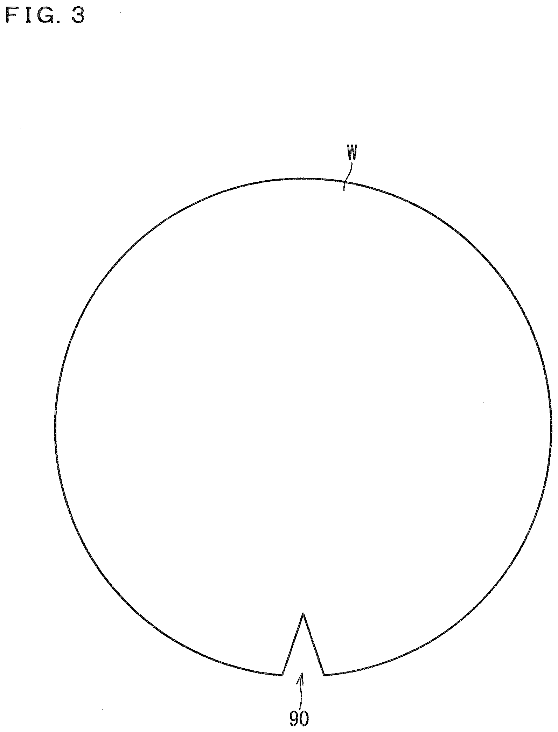

A treatment operation in the substrate treatment apparatus 1 is described next. Fig. 2 is a flow chart illustrating a procedure of the treatment operation in the substrate treatment apparatus 1. Fig. 3 is a plan view of the substrate W to be treated in the substrate treatment apparatus 1. The substrate W is a silicon semiconductor wafer having substantially a disk-like shape. In the present embodiment, the diameter of the substrate W is 300 mm. As illustrated in Fig. 3, formed in the substrate W is a notch 90 as a groove having a V-like shape for indicating a crystal orientation. The notch 90 is a notched part provided to the substrate W. A size of the notch 90 is exaggeratingly illustrated in Fig. 3 for the sake of easier understanding, however, the diameter of the substrate W is 300 mm, and in contrast, a depth of the notch 90 (distance from an outer surrounding end of the substrate W to a tip end of a V shape of the notch 90) is about 1.5 mm.

Before the substrate W is transported into the substrate treatment apparatus 1, a resist film is formed on the substrate W by a coating-developing apparatus (coater-developer) provided separately from the substrate treatment apparatus 1, and a development treatment is performed on the resist film on which a pattern exposure is performed to form a pattern. The resist film is removed from the peripheral edge part of the substrate W immediately after the formation of the resist film to prevent occurrence of dust caused by contact of the end edge part of the substrate W where the resist film is formed with the transfer arm or the positioning part. Accordingly, a silicon base material is exposed in the peripheral edge part of the substrate W. The peripheral edge part of substrate W is a region on an outer side (end edge part side) of the region where the pattern is formed, and more specifically, a region within 3 mm from the end edge part toward the center side of the substrate W. Thus, the notch 90 is provided to the peripheral edge part of the substrate W, and does not have influence on the region where the pattern is formed.

The substrate W where the pattern formation is performed and the resist film is removed from the peripheral edge part is transported into the substrate treatment apparatus 1 by a transfer robot not illustrated in the diagrams, and is held by the rotation holding part 10 (Step S1). The spin chuck 11 of the rotation holding part 10 sucks the center part of the lower surface of the substrate W and holds the substrate W in the horizontal posture.

Next, the rotation holding part 10 rotates the substrate W a certain degrees smaller than 360 degrees to adjust an orientation of the substrate W (Step S2). Specifically, previously obtained is a position at which a trajectory of the coating nozzle 30 moved by the nozzle drive mechanism 32 and the end edge part of the substrate W intersect with each other when seen from an upper side, and the position is stored in a storage part of the controller 50, for example. The controller 50 controls the rotation holding part 10, rotates the substrate W to move the notch 90 in the above intersecting position based a detection result of the notch detection mechanism 20, and adjusts the orientation of the substrate W. In the first embodiment, the rotation holding part 10 stops the rotation of the substrate W and holds the substrate W in a stationary state at a point of time when the notch 90 reaches the intersecting position descried above and adjustment of the orientation of the substrate W is completed.

Subsequently, discharge of the coating solution from the coating nozzle 30 is started (Step S3). The coating nozzle 30 starts discharging the coating solution while the coating nozzle 30 stops in an initial position inside the cup 40 on an outer side of the substrate W held by the spin chuck 11. The coating nozzle 30 discharges a solution for forming a photoresist or a bottom layer film as the coating solution. The coating nozzle 30 discharges the coating solution at a constant flow rate toward a lower side in a vertical direction. At this time, the coating nozzle 30 stands ready in the initial position on the outer side of the substrate W, thus the coating solution discharged from the coating nozzle 30 does not reach the substrate W but is collected by the cup 40.

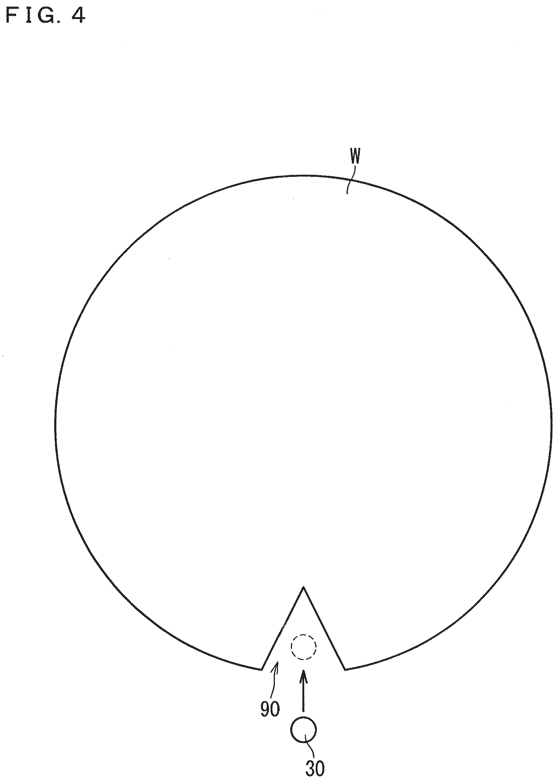

After a discharge state of the coating solution from the coating nozzle 30 becomes stable, the coating nozzle 30 moves to the upper side of the notch 90 of the substrate W held in the stationary state by the spin chuck 11 (Step S4). Fig. 4 is a plan view illustrating the coating nozzle 30 moving to the upper side of the notch 90 of the substrate W. The coating nozzle 30 discharging the coating solution toward the lower side is moved from the initial position on the outer side of the substrate W to the discharge position on the upper side of the notch 90 of the substrate W by the nozzle drive mechanism 32. More specifically, the storage part of the controller 50 previously stores a coordinate of the discharge position, and the controller 50 controls the nozzle drive mechanism 32 so that the coating nozzle 30 is moved to the discharge position based on a detection result of the encoder 33, for example. The coating nozzle 30 stops at the discharge position. At this time, the rotation of the substrate W is stopped, and the coating solution discharged from the coating nozzle 30 moved to the discharge position toward the lower side in the vertical direction passes through the notch 90 to drop into the cup 40. To be exact, the discharge position is a position of the coating nozzle 30 where a flow of the coating solution discharged from the coating nozzle 30 passes through the notch 90 of the substrate W whose orientation is adjusted in Step S2, and is a position getting close to the center side from the end edge part of the substrate W by a predetermined distance.

After the coating nozzle 30 discharging the coating solution is stopped at the discharge position, the rotation holding part 10 starts rotating the substrate W held in the horizontal posture. The spin motor 12 of the rotation holding part 10 rotates the substrate W around the central axis X of the substrate W in a horizontal plane. **In** the first embodiment, the rotation holding part 10 rotates the substrate W only once (360 degrees) in the horizontal plane (Step S5).

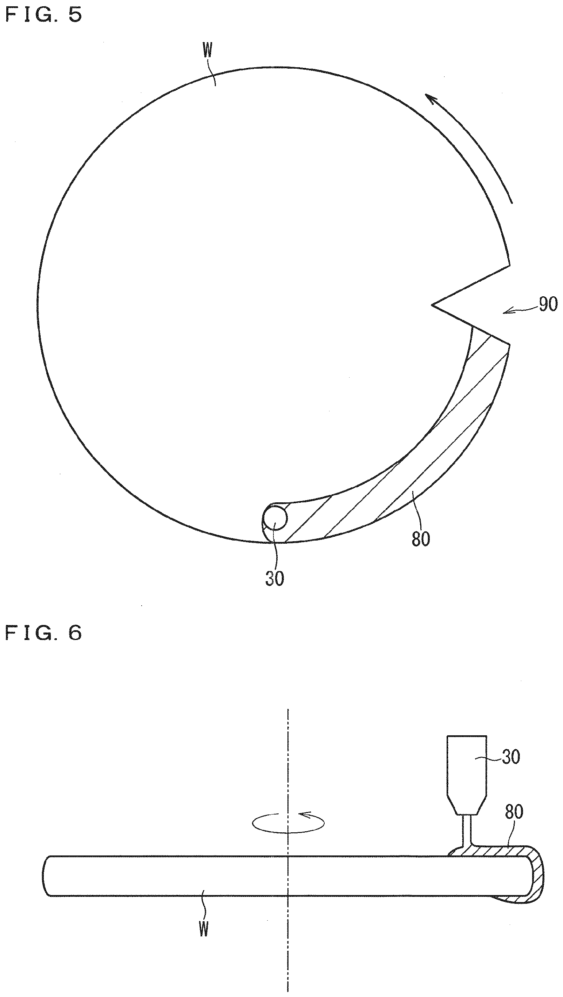

When the substrate W is rotated around the central axis X in the horizontal plane while the coating solution is discharged from the coating nozzle 30 stopped at the discharge position toward the lower side in the vertical direction, the coating solution is supplied to the peripheral edge part of the substrate W to form the coating film. Fig. 5 is a plan view illustrating formation of the coating film on the substrate W. Fig. 6 is a side view schematically illustrating formation of the coating film. When the rotation of the substrate W is started from a state illustrated in Fig. 4 while the coating solution is discharged from the coating nozzle 30 in the discharge position, application of the coating solution to the peripheral edge part of the substrate W is started from the notch 90 as a start point as illustrated in Fig. 5. The coating solution reaching the peripheral edge part of the substrate W flows to extend toward the end edge part of the substrate W by centrifugal force according to the rotation of the substrate W, and partially extends from the end edge part of the substrate W to a peripheral edge part of the lower surface thereof. The coating solution reaching the peripheral edge part of the substrate W also partially extends to the center side of the substrate W by surface tension. As a result, the coating solution is applied to a region with a constant width from the end edge part on the upper surface of the peripheral edge part of the substrate W, and a coating film 80 is annularly formed.

When the substrate W is rotated once in the horizontal plane, the coating nozzle 30 is located on the upper side of the notch 90 again. At this point of time, the rotation holding part 10 stops rotating the substrate W. Accordingly, application of the coating solution to the peripheral edge part of the substrate W is finished at the notch 90 as a terminal point, and the coating film 80 with a constant width is formed on the upper surface of the peripheral edge part of the substrate W except for an area of the notch 90. The coating solution discharged from the coating nozzle 30 returning to the upper side of the notch 90 passes through the notch 90 in the manner similar to the state before the application and drops into the cup 40.

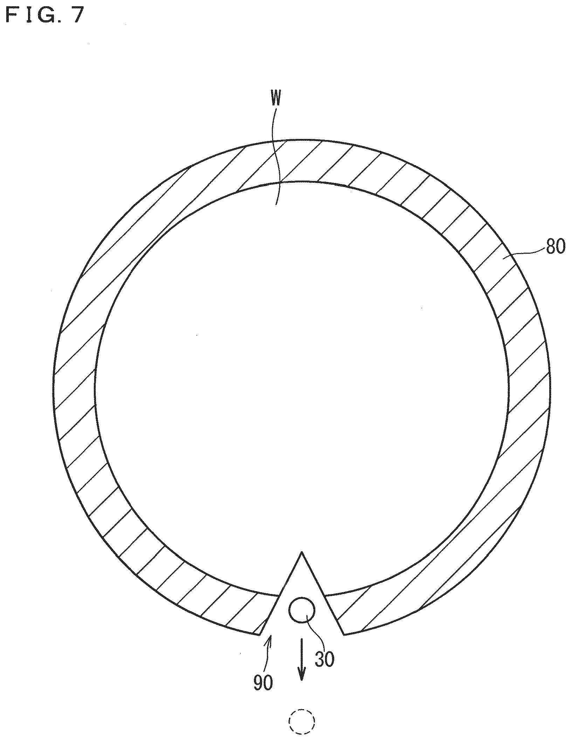

Subsequently, the coating nozzle 30 is moved to the initial position described above from the discharge position. That is to say, the coating nozzle 30 retracts from the upper side of the notch 90 of the substrate W which stops the rotation (Step S6). Fig. 7 is a plan view illustrating the coating nozzle 30 retracting from the upper side of the notch 90 of the substrate W. The coating nozzle 30 is returned to the initial position on the outer side of the substrate W from the upper side of the notch 90 of the substrate W by the nozzle drive mechanism 32. The initial position is a position where the coating solution discharged from the coating nozzle 30 passes through the outer side of the substrate W. The coating nozzle 30 stops at the initial position. The coating solution is continuously discharged from the coating nozzle 30 also when the coating nozzle 30 retracts from the upper side of the notch 90 of the substate W, and is collected by the cup 40.

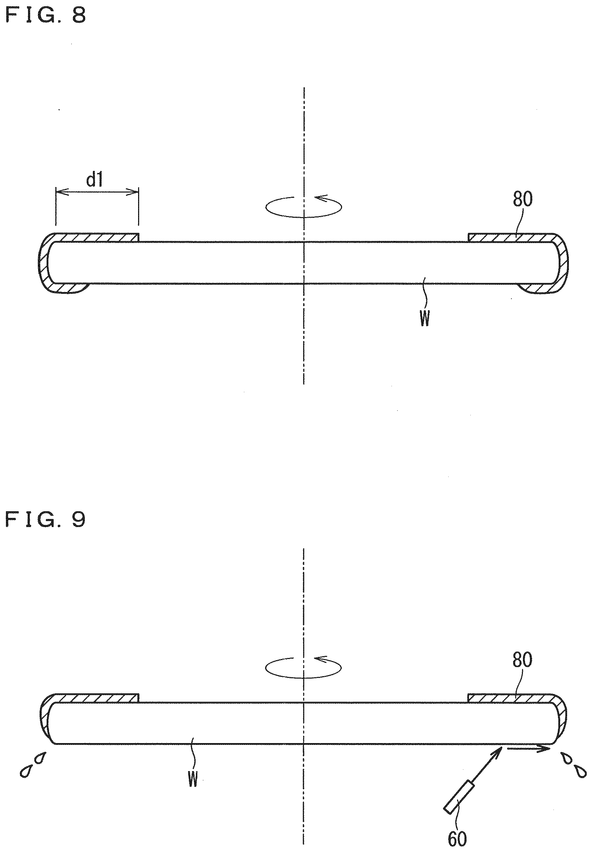

After the coating nozzle 30 returns to the initial position, discharge of the coting solution is stopped (Step S7). Next, the coating film 80 formed in the peripheral edge part of the substrate W is dried (Step S8). Fig. 8 is a diagram schematically illustrating drying of the coating film 80. Specifically, the controller 50 controls the operation of the spin motor 12 so that the number of rotations of the substrate W significantly gets large. A so-called spin drying is executed when the substrate W is rotated at a high speed, and the coating film 80 is dried. Accordingly, the coating film 80 with a constant width d1 is annularly formed on the upper surface of the peripheral edge part of the substrate W.

After the drying process, a back surface of the substrate W is cleaned (Step S9). Fig. 9 is a diagram schematically illustrating cleaning of the back surface of the substrate W. The coating solution partially extends from the end edge part to the peripheral edge part of the lower surface of the substrate W when the coating solution is supplied to the peripheral edge part of the rotated substrate W in Step S5. The coating solution extending to the lower surface of the substrate W is dried in the drying process in Step S8, and is firmly attached to the lower surface thereof as the coating film. In Step S9, such a coating film firmly attached to the lower surface of the substrate W is rinsed away. Specifically, a rinse solution is discharged from the back rinse nozzle 60 to the lower surface of the substrate W while rotating the substrate W. The rinse solution supplied to the lower surface of the substrate W flows to the end edge part side along the lower surface of the substrate W by centrifugal force. The coating film firmly attached to the lower surface of the substrate W is rinsed away by the flow of the rinse solution, and is removed.

Subsequently, the substrate W on which the coating film 80 is formed is transported from the substrate treatment apparatus 1 by a transfer robot not illustrated in the diagrams (Step S10). A DRIE process, for example, is performed as a post-process on the substrate W transported from the substrate treatment apparatus 1. In the DRIE process, the coating film 80 protects the upper surface of the peripheral edge part of the substrate W.

In the first embodiment, the coating nozzle 30 discharging the coating solution is moved to the upper side of the notch 90 of the substrate W held in the stationary state, and the substrate W is rotated only once in the horizontal plane to form the coating film 80 on the upper surface of the peripheral edge part of the substrate W. That is to say, application of the coating solution is started from the notch 90 of the substrate W, and is finished at the notch 90. As a result, the coating solution is applied only once with one stroke on the upper surface of the peripheral edge part of the substrate W (one coating). The substrate W is rotated only once, and the coating solution is applied only once to the peripheral edge part, thus a supply amount of the coating solution remains minimal. Suppressed accordingly is spread of the coating solution reaching the substrate W in the radial direction of the substrate W, and the coating film 80 with the narrow width can be formed. When the supply amount of the coating solution to the substrate W is reduced, partial bulge of the coating film 80 as a specific phenomenon in applying the coating solution to the peripheral edge part can also be suppressed.

**In** the first embodiment, the discharge of the coating solution is started before the coating nozzle 30 reaches the discharge position, thus the coating solution is applied to the peripheral edge part of the substrate W while the coating solution is stably discharged. That is to say, the coating solution is supplied at a constant flow rate to the peripheral edge part of the substrate W rotated at a constant speed, thus the coating film 80 with a uniform width can be formed.

However, even in a case where the substrate W is rotated at a constant speed and the coating solution is discharged from the coating nozzle 30 at a constant flow rate, if application of the coating solution is started from a position other than the notch 90 and, is finished at the position, slight overlapping of the coating solution occurs in the position, thus such a configuration interferes with formation of the uniform coating film 80.

In the first embodiment, application of the coating solution is started from the notch 90 of the substrate W, and is finished at the notch 90. The coating solution discharged from the coating nozzle 30 passes through the notch 90, and is collected by the cup 40 at the time of starting and finishing application. Accordingly, overlapping of the coating solution does not occur in the notch 90, thus the coating film 80 with a further uniform width can be formed. That is to say, according to the first embodiment, the coating film 80 with a uniform and narrow width can be formed.

### <Second embodiment>

Next, a second embodiment according to the present invention will be described. The configuration of the substrate treatment apparatus in the second embodiment is similar to that of the first embodiment (Fig. 1). The coating nozzle 30 proceeds to and retracts from the substrate W in the stationary state in the first embodiment, however, the coating nozzle 30 is moved to and from the rotated substrate W in the second embodiment.

Also in the second embodiment, the substrate W to be treated is a disk-shaped silicon semiconductor wafer in which the notch 90 is formed (Fig. 3). A pattern is formed on the substrate W by photolithography, the resist film is removed in the peripheral edge part of the substrate W, and a silicon base material is exposed. Such a substrate W is transported into the substrate treatment apparatus 1, and is held by the rotation holding part 10.

Next, the rotation of the substrate W held by the rotation holding part 10 in the horizontal posture is started in the second embodiment. The spin motor 12 of the rotation holding part 10 rotates the substrate W around the central axis X of the substrate W in a horizontal plane. The rotation holding part 10 rotates the substrate W at a preset constant number of rotations. The number of rotations of the substrate W in the second embodiment is equal to or smaller than 100 rpm, and is typically equal to or larger than 20 rpm and equal to or smaller than 30 rpm.

The position of the notch 90 of the rotated substrate W is derived based on the detection result by the notch detection mechanism 20. Specifically, when the notch 90 of the rotated substrate W passes through immediately a lower side of the notch detection mechanism 20 (or immediately an upper side thereof), the notch detection mechanism 20 detects the notch 90. The substrate W is rotated at a constant speed, the notch detection mechanism 20 periodically detects the notch 90 at regular intervals. The controller 50 calculates the position of the notch 90 based on an elapsed time after a point of time when the notch detection mechanism 20 detects the notch 90 and a rotation speed of the substrate W.

In the meanwhile, the coating nozzle 30 starts discharging the coating solution. The coating nozzle 30 starts discharging the coating solution while the coating nozzle 30 stops in the initial position inside the cup 40 on the outer side of the substrate W held by the spin chuck 11. The coating nozzle 30 discharges the coating solution at a constant flow rate toward the lower side in the vertical direction in the manner similar to the first embodiment.

In the second embodiment, after the discharge state of the coating solution from the coating nozzle 30 becomes stable, the coating nozzle 30 is moved to the upper side of the notch 90 of the rotated substrate W. The position of the notch 90 of the rotated substrate W is obtained based on the detection result by the notch detection mechanism 20 described above. The position of the coating nozzle 30 is detected by the encoder 33. The controller 50 controls the nozzle drive mechanism 32 so that the coating nozzle 30 also reaches a position at which a trajectory of the coating nozzle 30 moved by the nozzle drive mechanism 32 and the end edge part of the substrate W intersect with each other seen from an upper side at a timing when the notch 90 reaches the above intersecting position. The notch 90 of the substrate W and the coating nozzle 30 discharging the coating solution reach the intersecting position at the same time, and the flow of the coating solution discharged from the coating nozzle 30, which is moved to the upper side of the notch 90, enters the V-shaped groove of the notch 90. Then, the coating nozzle 30 is moved to the discharge position on the upper side of the notch 90 and stops at the discharge position. In the manner similar to the first embodiment, to be exact, the discharge position is a position of the coating nozzle 30 in which the flow of the coating solution discharged from the coating nozzle 30 passes through the notch 90 in the intersecting position described above.

The coating nozzle 30 advances to the notch 90 of the substrate W in the stationary state in the first embodiment, however, the coating nozzle 30 needs to be moved in synchronization with the notch 90 of the rotated substrate W in the second embodiment. Thus, the nozzle drive mechanism 32 preferably moves the coating nozzle 30 as high a speed as possible (for example, 20 mm per second or more). As the number of rotations of the substrate W increases, the coating nozzle 30 needs to be moved at higher speed.

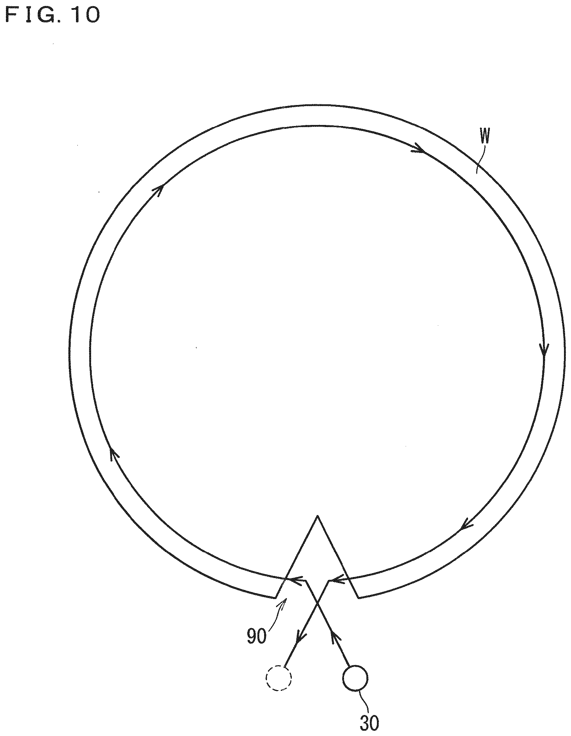

Fig. 10 is a diagram illustrating a trajectory of a relative movement of the coating nozzle 30 on the substrate W according to the second embodiment. The coating nozzle 30 is moved to and stops at the discharge position at the timing when the notch 90 of the rotated substrate W reaches the intersecting position described above, thus the coating nozzle 30 is moved to the upper side of the notch 90, and the flow of the coating solution enters the V-shaped groove of the notch 90.

The substrate W is continuously rotated even after the coating nozzle 30 discharging the coating solution stops at the discharge position. When the substrate W is rotated around the central axis X in the horizontal plane while the coating solution is discharged from the coating nozzle 30 stopped at the discharge position toward the lower side in the vertical direction, the coating solution is supplied to the peripheral edge part of the substrate W to form the coating film 80. Also in the second embodiment, the flow of the coating solution firstly enters the notch 90, thus the application of the coating solution to the peripheral edge part of the substrate W is started from the notch 90 as a start point. The coating solution reaching the peripheral edge part of the substrate W flows to extend toward the end edge part of the substrate W by centrifugal force according to the rotation of the substrate W, and partially extends from the end edge part of the substrate W to the peripheral edge part of the lower surface thereof. The coating solution reaching the peripheral edge part of the substrate W also partially extends to the center side of the substrate W by surface tension. As a result, the coating solution is applied to the region with the constant width from the end edge part on the upper surface of the peripheral edge part of the substrate W, and the coating film 80 is annularly formed.

When the substrate W is rotated once in the horizontal plane, the coating nozzle 30 is located on the upper side of the notch 90 again. In the second embodiment, the coating nozzle 30 is moved from the discharge position to the initial position at a timing when the coating nozzle 30 is located on the upper side of the notch 90 again. That is to say, the coating nozzle 30 retracts from the upper side of the notch 90 of the substrate W. Accordingly, application of the coating solution to the peripheral edge part of the substrate W is finished at the notch 90 as the terminal point, and the annular coating film 80 with the constant width is formed on the upper surface of the peripheral edge part of the substrate W except for the area of the notch 90. The initial position is the position where the coating solution discharged from the coating nozzle 30 passes through the outer side of the substrate W. The substrate W is continuously rotated also when the coating nozzle 30 retracts from the upper side of the notch 90. The coating nozzle 30 stops at the initial position.

Subsequently, discharge of the coating solution from the coating nozzle 30 is stopped in the manner similar to the first embodiment. Then, when the substrate W is rotated at a high speed, the coating film 80 formed in the peripheral edge part of the substrate W is dried. Accordingly, the coating film 80 with the constant width is formed on the upper surface of the peripheral edge part of the substrate W. Finally, a rinse solution is discharged from the back rinse nozzle 60 to the lower surface of the substrate W while rotating the substrate W, and the coating film firmly attached to the lower surface thereof is rinsed away, and is removed.

In the second embodiment, the coating nozzle 30 discharging the coating solution is moved to the upper side of the notch 90 of the rotated substrate W, and the substrate W is continuously rotated only once in the horizontal plane to form the coating film 80 on the upper surface of the peripheral edge part of the substrate W. That is to say, application of the coating solution is started from the notch 90 of the substrate W, and is finished at the notch 90 in the manner similar to the first embodiment. As a result, the coating solution is applied only once with one stroke on the upper surface of the peripheral edge part of the substrate W. The coating solution is applied only once to the peripheral edge part of the substrate W, thus the supply amount of the coating solution remains minimal. Suppressed accordingly is spread of the coating solution reaching the substrate W in the radial direction of the substrate W, and the coating film 80 with the narrow width can be formed.

The discharge of the coating solution is started before the coating nozzle 30 reaches the discharge position, thus the coating solution is applied to the peripheral edge part of the substrate W while the coating solution is stably discharged. That is to say, the coating solution is supplied at a constant flow rate to the peripheral edge part of the substrate W rotated at a constant speed, thus the coating film 80 with a uniform width can be formed.

Furthermore, also in the second embodiment, application of the coating solution is started from the notch 90 of the substrate W, and is finished at the notch 90. The coating solution discharged from the coating nozzle 30 passes through the notch 90, and is collected by the cup 40 at the time of starting and finishing application. Accordingly, overlapping of the coating solution does not occur in the notch 90, thus the coating film 80 with a further uniform width can be formed. In addition, in the second embodiment, the coating nozzle 30 is moved at a high speed, and is rapidly stopped at the discharge position, thus the coating nozzle 30 is vibrated at a moment of stopping and turbulence occurs in the flow of the coating solution. However, the turbulent flow passes through the notch 90, and does not reach the substrate W, thus does not have influence on the formation of the coating film 80 with a uniform width. That is to say, according to the second embodiment, the coating film 80 with a uniform and narrow width can be formed.

### <Modification example>

While the embodiments according to the present invention have been described hereinabove, various modifications of the present invention are possible in addition to those described above without departing from the scope and spirit of the present invention. For example, the notch 90 is formed in the substrate W, however, an orientation flat may be provided to the substrate W in place of the notch 90. The orientation flat is a flat notch part indicating a crystal orientation in the manner similar to the notch 90. The orientation flat is typically formed in the relatively small substrate W having a diameter of 200 mm. In this case, application of the coating solution is started from the orientation flat, and is finished at the orientation flat. Both the notch 90 and the orientation flat are notched parts provided to the substrate W.

In each embodiment described above, discharge of the coating solution is started before the coating nozzle 30 reaches the discharge position, however, the discharge of the coating solution may be started after the coating nozzle 30 reaches the discharge position instead. According to such a configuration, a consumption amount of the coating solution can be reduced. However, the application can be started while the coating solution is discharged more stably when the discharge of the coating solution is started before the coating nozzle 30 reaches the discharge position, and the coating film 80 with a further uniform width can be formed.

In the first embodiment, the orientation of the substrate W is adjusted in the substrate treatment apparatus 1, however, the orientation of the substrate W may be adjusted in the other apparatus before the substrate 1 is transported into the substrate treatment apparatus 1 instead. The adjusted orientation of substrate W is maintained unless substrate W is rotated in the process of transporting the substrate W.

The resist film or the bottom layer film is formed as the coating film 80 in each embodiment described above. However, the coating film 80 is not limited thereto, but any film is applicable as long as a film functions as a protection film having resistance to an etching treatment such as DRIE.

The coating solution is discharged from the coating nozzle 30 toward a vertically lower side in each embodiment described above, however, the coating solution may be alternatively discharged from the coating nozzle 30 toward an obliquely lower side (toward the end edge part of the substrate W). In this case, the discharge position of the coating nozzle 30 may be different from the upper side of the notch 90.

While the invention has been shown and described in detail, the foregoing description is in all aspects illustrative and not restrictive. It is therefore understood that numerous modifications and variations can be devised without departing from the scope of the invention. which is defined by the appended claims.

## Claims

1. A substrate treatment method of forming a coating film (80) on a peripheral edge part of a disk-shaped substrate (W) having a notched part (90), comprising steps of:
(a) moving a nozzle (30) discharging a coating solution for forming the coating film to a discharge position where a flow of the coating solution discharged from the nozzle passes through the notched part of the substrate held in a horizontal posture; and
(b) rotating the substrate once in a horizontal plane around a central axis of the substrate while discharging the coating solution from the nozzle in the discharge position, starting application of the coating solution from the notched part, and finishing application of the coating solution at the notched part.

2. The substrate treatment method according to claim 1, further comprising a step of:
(c) after the step (b), moving the nozzle to a position where the flow of the coating solution discharged from the nozzle passes through an outer side of the substrate.

3. The substrate treatment method according to claim 2, wherein
the step (a) and the step (c) are executed while the rotation of the substrate is stopped.

4. The substrate treatment method according to claim 2, wherein
the step (a) and the step (c) are executed while the substrate is rotated.

5. The substrate treatment method according to any one of claims 1 to 4, wherein
discharge of the coating solution from the nozzle is started before the nozzle reaches the discharge position.

6. A substrate treatment apparatus forming a coating film (80) on a peripheral edge part of a disk-shaped substrate (W) having a notched part (90), comprising:
a rotation holding part (10) rotating the substrate around a central axis of the substrate while holding the substrate in a horizontal posture;
a nozzle (30) discharging a coating solution for forming the coating film;
a nozzle drive part (32) moving the nozzle between an upper side and an outer side of the substrate; and
a controller (50) controlling the rotation holding part and the nozzle drive part, wherein
the controller controls the nozzle drive part so that the nozzle is moved to a discharge position where a flow of the coating solution discharged from the nozzle passes through the notched part of the substrate held by the rotation holding part, and
the controller controls the rotation holding part so that the rotation holding part rotates the substrate once in a horizontal plane around a central axis of the substrate while discharging the coating solution from the nozzle in the discharge position, application of the coating solution is started from the notched part, and application of the coating solution is finished at the notched part.

7. The substrate treatment apparatus according to claim 6, wherein
the controller controls the nozzle drive part so that the nozzle drive part moves the nozzle to a position where the flow of the coating solution discharged from the nozzle passes through an outer side of the substrate after the application of the coating solution.

8. The substrate treatment apparatus according to claim 7, wherein
the controller controls the nozzle drive part so that the nozzle drive part moves the nozzle to the discharge position and moves the nozzle from the discharged position while the rotation of the substrate is stopped.

9. The substrate treatment apparatus according to claim 7, wherein
the controller controls the nozzle drive part so that the nozzle drive part moves the nozzle to the discharge position and moves the nozzle from the discharged position while the substrate is rotated.

10. The substrate treatment apparatus according to any one of claims 6 to 9, wherein
discharge of the coating solution is started before the nozzle reaches the discharge position.

## Patentansprüche

1. Substratbehandlungsverfahren zum Bilden eines Beschichtungsfilms (80) auf einem Umfangskantenteil eines scheibenförmigen Substrats (W) mit einem gekerbten Teil (90), umfassend die folgenden Schritte:
(a) Bewegen einer Düse (30), die eine Beschichtungslösung zur Bildung des Beschichtungsfilms ausstößt, in eine Ausstoßposition, in der ein Fluss der aus der Düse ausgestoßenen Beschichtungslösung den eingekerbten Teil des in einer horizontalen Stellung gehaltenen Substrats passiert; und
(b) einmaliges Drehen des Substrats in einer horizontalen Ebene um eine zentrale Achse des Substrats, während die Beschichtungslösung aus der Düse in der Ausstoßposition ausgestoßen wird, Beginnen des Auftragens der Beschichtungslösung bei dem gekerbten Teil und Beenden des Auftragens der Beschichtungslösung bei dem gekerbten Teil.

2. Substratbehandlungsverfahren nach Anspruch 1, ferner umfassend einen Schritt:
(c) nach dem Schritt (b) des Bewegens der Düse in eine Position, in der der aus der Düse ausgestoßene Fluss der Beschichtungslösung eine Außenseite des Substrats passiert.

3. Substratbehandlungsverfahren nach Anspruch 2, wobei
der Schritt (a) und der Schritt (c) ausgeführt werden, während die Drehung des Substrats angehalten wird.

4. Substratbehandlungsverfahren nach Anspruch 2, wobei
der Schritt (a) und der Schritt (c) ausgeführt werden, während das Substrat gedreht wird.

5. Substratbehandlungsverfahren nach einem der Ansprüche 1 bis 4, wobei
das Ausstoßen der Beschichtungslösung aus der Düse beginnt, bevor die Düse die Ausstoßposition erreicht.

6. Substratbehandlungsvorrichtung, die einen Beschichtungsfilm (80) auf einem Umfangskantenteil eines scheibenförmigen Substrats (W) mit einem gekerbten Teil (90) bildet, umfassend:
einen Drehhalteteil (10), der das Substrat, während des Haltens in einer horizontalen Position, um eine zentrale Achse des Substrats dreht;
eine Düse (30), die eine Beschichtungslösung zur Bildung des Beschichtungsfilms ausstößt;
einen Düsenantriebsteil (32), der die Düse zwischen einer Oberseite und einer Außenseite des Substrats bewegt; und
eine Steuerung (50), die den Drehhalteteil und den Düsenantriebsteil steuert, wobei
die Steuerung den Düsenantriebsteil derart steuert, dass die Düse in eine Ausstoßposition bewegt wird, in der ein Fluss der aus der Düse ausgestoßenen Beschichtungslösung den eingekerbten Teil des vom Drehhalteteil gehaltenen Substrats passiert, und
die Steuerung den Drehhalteteil derart steuert, dass der Drehhalteteil das Substrat einmal in einer horizontalen Ebene um eine zentrale Achse des Substrats dreht, während die Beschichtungslösung aus der Düse in der Ausstoßposition ausgestoßen wird, der Auftrag der Beschichtungslösung bei dem eingekerbten Teil begonnen wird und der Auftrag der Beschichtungslösung bei dem eingekerbten Teil beendet wird.

7. Substratbehandlungsvorrichtung nach Anspruch 6, wobei
die Steuerung den Düsenantriebsteil derart steuert, dass der Düsenantriebsteil die Düse in eine Position bewegt, in der der aus der Düse ausgestoßene Fluss der Beschichtungslösung nach dem Auftragen der Beschichtungslösung eine Außenseite des Substrats passiert.

8. Substratbehandlungsvorrichtung nach Anspruch 7, wobei
die Steuerung den Düsenantriebsteil derart steuert, dass der Düsenantriebsteil die Düse in die Ausstoßposition bewegt und die Düse aus der Ausstoßposition bewegt, während die Drehung des Substrats angehalten wird.

9. Substratbehandlungsvorrichtung nach Anspruch 7, wobei
die Steuerung den Düsenantriebsteil derart steuert, dass der Düsenantriebsteil die Düse in die Ausstoßposition bewegt und die Düse aus der Ausstoßposition bewegt, während das Substrat gedreht wird.

10. Substratbehandlungsvorrichtung nach einem der Ansprüche 6 bis 9, wobei
das Ausstoßen der Beschichtungslösung beginnt, bevor die Düse die Ausstoßposition erreicht.

## Revendications

1. Procédé de traitement de substrat consistant à former un film de revêtement (80) sur une partie de bord périphérique d'un substrat (W) en forme de disque ayant une partie échancrée (90), comprenant les étapes consistant à :
(a) déplacer une buse (30) déchargeant une solution de revêtement destinée à former le film de revêtement vers une position de décharge dans laquelle un flux de la solution de revêtement déchargée depuis la buse traverse la partie échancrée du substrat maintenu dans une posture horizontale ;
(b) faire tourner le substrat une fois dans un plan horizontal autour d'un axe central du substrat tout en déchargeant la solution de revêtement depuis la buse dans la position de décharge, en commençant l'application de la solution de revêtement à partir de la partie échancrée, et en terminant l'application de la solution de revêtement au niveau de la partie échancrée.

2. Procédé de traitement de substrat selon la revendication 1, comprenant en outre une étape consistant à :
(c) après l'étape (b), déplacer la buse vers une position dans laquelle le flux de la solution de revêtement déchargée depuis la buse passe à travers un côté extérieur du substrat.

3. Procédé de traitement de substrat selon la revendication 2, dans lequel
l'étape (a) et l'étape (c) sont exécutées pendant que la rotation du substrat est arrêtée.

4. Procédé de traitement de substrat selon la revendication 2, dans lequel
l'étape (a) et l'étape (c) sont exécutées pendant que le substrat est en rotation.

5. Procédé de traitement de substrat selon l'une quelconque des revendications 1 à 4, dans lequel
la décharge de la solution de revêtement depuis la buse est commencée avant que la buse n'atteigne la position de décharge.

6. Appareil de traitement de substrat formant un film de revêtement (80) sur une partie de bord périphérique d'un substrat (W) en forme de disque ayant une partie échancrée (90), comprenant :
une partie de maintien en rotation (10) faisant tourner le substrat autour d'un axe central du substrat tout en maintenant le substrat dans une posture horizontale ;
une buse (30) déchargeant une solution de revêtement destinée à former le film de revêtement ;
une partie d'entraînement de buse (32) déplaçant la buse entre un côté supérieur et un côté extérieur du substrat ; et
un organe de commande (50) commandant la partie de maintien en rotation et la partie d'entraînement de buse,
l'organe de commande commandant la partie d'entraînement de buse de manière à ce que la buse soit déplacée vers une position de décharge dans laquelle un flux de la solution de revêtement déchargée depuis la buse passe à travers la partie échancrée du substrat maintenu par la partie de maintien en rotation, et
l'organe de commande commandant la partie de maintien en rotation de manière à ce que la partie de maintien en rotation fasse tourner le substrat une fois dans un plan horizontal autour d'un axe central du substrat tout en déchargeant la solution de revêtement depuis la buse dans la position de décharge, l'application de la solution de revêtement étant commencée à partir de la partie échancrée, et l'application de la solution de revêtement étant terminée au niveau de la partie échancrée.

7. Appareil de traitement de substrat selon la revendication 6, dans lequel
l'organe de commande commande la partie d'entraînement de buse de manière à ce que la partie d'entraînement de buse déplace la buse vers une position dans laquelle le flux de la solution de revêtement déchargée depuis la buse passe à travers un côté extérieur du substrat après l'application de la solution de revêtement.

8. Appareil de traitement de substrat selon la revendication 7, dans lequel
l'organe de commande commande la partie d'entraînement de buse de manière à ce que la partie d'entraînement de buse déplace la buse vers la position de décharge et déplace la buse depuis la position de décharge pendant que la rotation du substrat est arrêtée.

9. Appareil de traitement de substrat selon la revendication 7, dans lequel
l'organe de commande commande la partie d'entraînement de buse de manière à ce que la partie d'entraînement de buse déplace la buse vers la position de décharge et déplace la buse depuis la position de décharge pendant que le substrat est en rotation.

10. Appareil de traitement de substrat selon l'une quelconque des revendications 6 à 9, dans lequel
la décharge de la solution de revêtement est commencée avant que la buse n'atteigne la position de décharge.
